# EUROPEAN PATENT APPLICATION

(11) **EP 1 168 446 A2**
(43) Date of publication of application: **02.01.2002**
(21) Application number: 01305114.9
(22) Date of filing: 12.06.2001
(51) Int. Cl.: H01L 25/07

(54) **Housing semiconductor chips**

(30) Priority: 23.06.2000 GB 0015484; 08.03.2001 GB 0105732
(71) Applicant: Westcode Semiconductors Limited, Bristol, BS99 7QQ (GB)
(72) Inventor: Neal, Howard Donald, Chippenham, Wiltshire SN15 3UT (GB); Irons, Robert Charles, Chippenham, Wiltshire SN15 3ST (GB)
(74) Representative: Newstead, Michael John

(57) **Abstract**

A housing arrangement for a plurality of semiconductor chips (1) is disclosed, in which each of the chips is received in a respective frame or cassette (4), there being a first electrically conductive member (5), having portions (6) which are in electrical connection with one face of each of the chips and a second electrically conductive member (7), having portions (8) which are in electrical connection with an opposite face of each of the chips.

## Description

The present invention relates to housing semiconductor chips.

In recent years, considerable interest has been shown in pressure contacted insulated gate bipolar transistor (IGBT) power devices. Since the size and therefore the power rating of an individual chip is quite low, this requires that the encapsulation consists of an array of such chips, in contrast to more traditional pressure contacted power devices which always use a single large chip.

A number of ways of achieving this are known. In one such example, the chips are held in a fixed array by a frame of plastics material. In another, a frame is stuck on to a chip and the chips butted together on a molybdenum disk.

While both of these solutions have been shown to work, consideration of the movement and forces within the encapsulation due to thermal expansion show the potential to generate wear, which potential increases with the size (i.e. power) of the encapsulation.

In the first example above, this comes about because the chips try to move their positions relative to the centre of the encapsulation with the expansion coefficient of the frame material, while the contacting copper pole pieces expand with the expansion coefficient of copper.

In the second example, the chips are butted together and the outer chips move with the coefficient of expansion of silicon and the molybdenum disk with its expansion coefficient, while the copper and molybdenum also show relative movement.

In all these cases, the relative movement is proportional to the distance from the centre of the encapsulation. As the encapsulated device is made larger, the movement on the outer chips increases.

As particular pieces of prior art, there may be mentioned EP-A-0 962 973, EP-A-0 746 023, EP-A-0 645 816, EP-A-0 637 080 and US-A-5 874 774.

According to the present invention, there is provided a housing arrangement for a plurality of semiconductor chips, in which each of said chips is received in a respective frame to form a discrete sub-assembly, there being a first electrically conductive member, having portions which are in electrical connection with one face of each of the chips, and a second electrically conductive member, having portions which are in electrical connection with an opposite face of each of the chips, a local axis of each of said chips and its respective connecting portions being free to move by thermal expansion relative to such a local axis of any other of said chips and its connecting portions, substantially without transferring stress between any of said chips.

In each of the frames there may be respective contact shims between said faces of the respective chip and the respective connecting portions.

The frames may be shaped so that, for each two adjacent frames, a projection on one side wall face of one of them enters into a recess of a side wall face of the other.

At least some of the frames may each be formed with a channel receiving a contact pin for the respective chip.

The present invention will now be described, by way of example, with reference to the accompanying drawings, in which:-
Fig. 1 is a section through part of an arrangement according to an example of the invention;
Fig. 2 is an exploded view of a frame/shims/chip sub-assembly for an example of the invention; and
Figs. 3 and 4 are a plan view and a perspective view of a group of alternative frame structures.

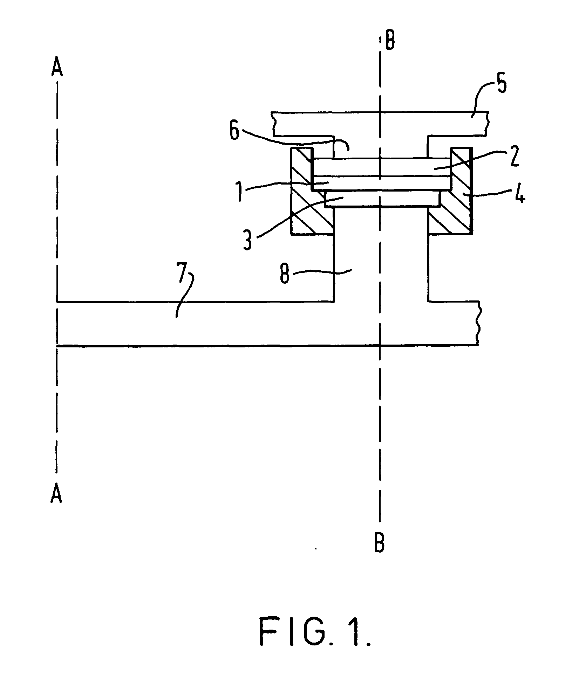

In Fig. 1, reference numeral 1 designates one of a plurality of silicon chips each sandwiched between a respective pair of molybdenum shims 2 and 3 and received in a respective frame 4. Shim 2 is, by way of example, a collector contact shim, shim 3 being an emitter contact shim. Each chip 1 and its shims 2 and 3 and the respective frame or cassette 4 forms a discrete sub-assembly, there being no solder connections in the sub-assembly.

Reference numeral 5 designates a copper member having portions 6 contacting all the shims 2 and reference numeral 7 designates a copper member having pillars 8 contacting respective ones of the shims 3, to provide a housing for the various chips 1 in their frames 4. Accordingly, portions 6 are in electrical connection with collector faces of respective ones of chips 1, pillars 8 being in electrical connection with emitter faces of respective ones of chips 1.

A-A designates the centre line of the encapsulation, each arrangement 6, 2, 3, 4, 8 having a respective local axis B-B.

As the portions 6 and pillars 8 are both copper, the local axis B-B will remain vertical even though its movement from the centre line A-A of the encapsulation may be large.

Whatever this movement however, it does not affect the relative movement of the silicon/molybdenum/copper sub-assembly whose relative movement is about the local axis B-B. This relative movement is:
a) small - because of the small chip size;
b) independent of distance from the centre line A-A;
c) identical for all the chips in the array.

Thus the local axis B-B of each chip 1 and its connecting portions 6 and 8 is free to move by thermal expansion relative to the local axis of any other of the chips and its connecting portions, substantially without transferring stress between any of the chips.

There could be, for example, thirty seven chips 1. In one such embodiment of this, all the chips could be IGBT chips with a current rating of approximately 3000A for example. In a second such embodiment, there could be twenty-eight IGBT chips and nine diode chips, with a current rating of 2200A for example. The overall housing arrangement could be about 100mm diameter for example.

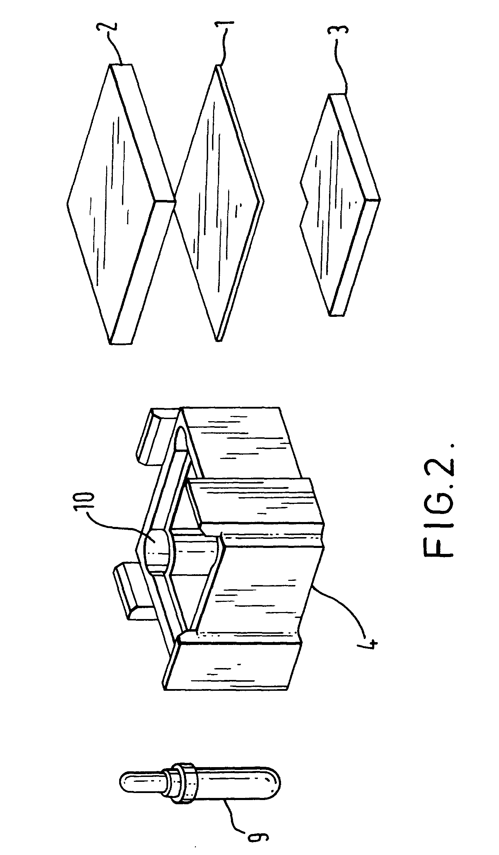

Referring to Fig. 2, which is an exploded view of a frame/shims/chip sub-assembly for use as in Fig. 1, shims 2 and chip 1 are square and shim 3 is generally square but has a cut-out at one of its corners through which a gate contact pin 9 passes to contact the chip 1, the pin also passing through a respective insulated opening in copper member 7 to act as in EP-A-0 923 127 for example. Reference numeral 10 designates a passageway formed in frame 4 to receive pin 9.

A disadvantage of the system described above is the increased space occupied by the side walls of the frames 4 since the replacement of a single multi-chip locator preform by a plurality of single-chip locator frames 4 places two side walls between each chip location.

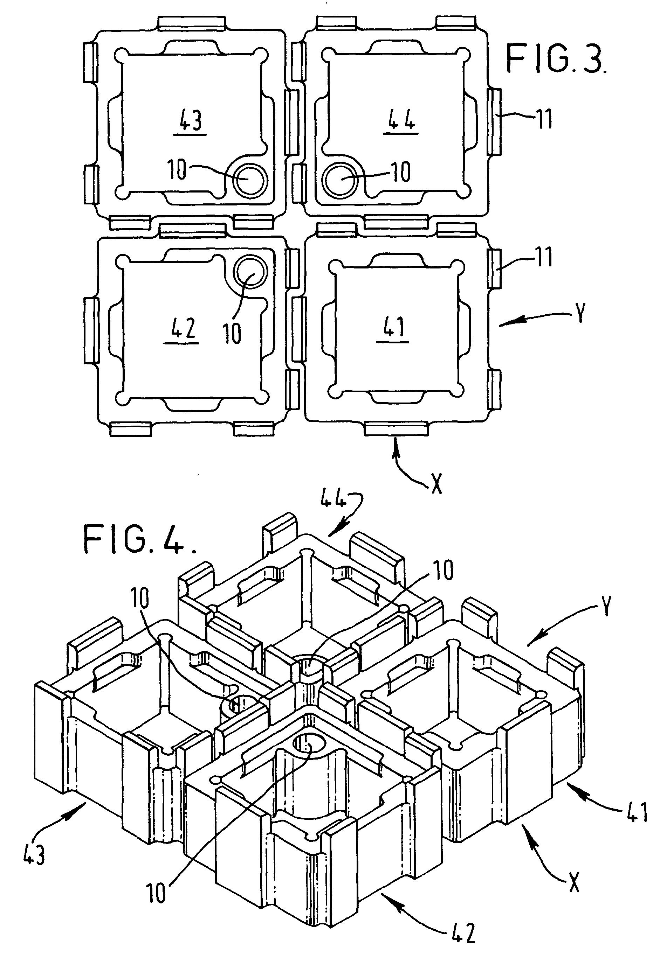

In a further example of the invention, the frames 4, instead of being as shown in Fig. 2, are as illustrated in Figs. 3 and 4. More particularly, the side walls of the frames 4 are made columnar in form so that they become discontinuous in horizontal section while still providing positive constraints to the positions of the captivated chips. The positions of the columns 11 are so arranged that adjacent frames 41, 42, 43 and 44 fit in a pattern with substantially only a single side wall thickness between each chip position. By defining two side wall types for any face of a rectangular frame, the types being denoted X (with a column 11 in the middle of each of two adjacent side wall faces) and Y (with a column 11 at each edge of each of the adjacent side wall faces) such that for any side wall face X its column 11 may enter into the space between columns 11 of any other side wall face Y, and by arranging the side wall faces in the rotational sequence X-X-Y-Y on each frame, a compact assembly of unlimited size can be achieved. Moreover, there is a choice of two methods of compact assembly. In the first, all rows and all columns of the assembly will face in one respective direction. In the second method, the respective directions of each row and each column will alternate.

In each case, for two adjacent frames, a projection on one side wall face of one of them (provided by a column 11 in the middle of the side wall face) enters into a recess of the other (provided between the columns 11 at opposite edges of the side wall face).

Each gate channel 10, occupied by a gate contact pin, may be in any corner of the particular frame 41, 42, 43 or 44 but only one style of IGBT frame is required. In the example, each channel is shown at the corner defined by a clockwise transition from an X face to a Y face. Some positions may be occupied by a diode chip instead of an IGBT chip, in which case a different frame 41, 42, 43 or 44, without a channel, is provided, but the wall arrangement remains identical, this being shown in Figs. 3 and 4, in which frames 41, 42 and 43 each has a gate channel 10 but frame 44 does not.

A specific advantage of the alternative style of assembly is that the gate pin channels 10 arrange themselves in groups of up to four at abutting corners. This has the desirable effect of simplifying the means of gate signal distribution within the assembly.

In the examples of the invention, rather than a single locating frame to take all the chips, each has its own individual frame. An individual sub-assembly for each chip allows for a reduction in the number of component interfaces and a simplification of the pre-testing of chips prior to final package assembly - i.e. if a chip fails replacement of it is more straightforward.

## Claims

1. A housing arrangement for a plurality of semiconductor chips, in which each of said chips is received in a respective frame to form a discrete sub-assembly, there being a first electrically conductive member, having portions which are in electrical connection with one face of each of the chips, and a second electrically conductive member, having portions which are in electrical connection with an opposite face of each of the chips, a local axis of each of said chips and its respective connecting portions being free to move by thermal expansion relative to such a local axis of any other of said chips and its connecting portions, substantially without transferring stress between any of said chips.

2. An arrangement according to claim 1, wherein in each of the frames there are respective contact shims between said faces of the respective chip and the respective connecting portions.

3. An arrangement according to claim 1 or 2, wherein the frames are shaped so that, for each two adjacent frames, a projection on one side wall face of one of them enters into a recess of a side wall face of the other.

4. An arrangement according to any preceding claim, wherein at least some of the frames are each formed with a channel receiving a contact pin for the respective chip.
